# EUROPEAN PATENT APPLICATION

(11) **EP 2 149 915 A2**
(43) Date of publication of application: **03.02.2010**
(21) Application number: 09004691.3
(22) Date of filing: 31.03.2009
(51) Int. Cl.: H01L 31/18, H01L 31/0236

(54) **Method of manufacturing photovoltaic device**

(30) Priority: 31.07.2008 KR 20080075261
(71) Applicant: Samsung Electronics Co., Ltd., Yeongtong-gu Suwon-city, Gyeonggi-do 442-742 (KR)
(72) Inventor: Oh, Min-Seok, Yongin-si, Gyeonggi-do (KR); Park, Min, Seoul (KR); Lee, Czang-Ho, Hwaseong-si, Gyeonggi-do (KR); Shin, Myung-Hun, Suwon-si, Gyeonggi-do (KR); Lee, Byoung-Kyu, Suwon-si, Gyeonggi-do (KR); Nam, Yuk-Hyun, Goyang-si, Gyeonggi-do (KR); Jung, Seung-Jae, Seoul (KR); Lim, Mi-Hwa, Chungcheongnam-do (KR); Seo, Joon-Young, Seoul (KR)
(74) Representative: Schmidt, Sven Hendrik

(57) **Abstract**

A method of manufacturing a photovoltaic device includes preparing a semiconductor substrate having a light incidence surface receiving light and including single crystalline silicon, wet-etching the light incidence surface to form a plurality of first protrusions on the light incidence surface, dry etching a plurality of surfaces of the first protrusions to form a plurality of second protrusions on the plurality of surfaces of the first protrusions, and forming a semiconductor layer on the light incidence surface. The method further includes forming a first electrode on the semiconductor layer and forming a second electrode on a rear surface of the semiconductor substrate facing the light incidence surface.

## Description

### CROSS-REFERENCE TO RELATED APPLICATION

This application relies for priority upon Korean Patent Application No. 2008-75261 filed on July 31, 2008, the contents of which are hereby incorporated by reference herein in their entirety.

### BACKGROUND

### 1. Technical Field

The present disclosure relates to a method of manufacturing a photovoltaic device. More particularly, the present disclosure relates to a method of manufacturing a photovoltaic device capable of improving photoelectric conversion efficiency.

### 2. Description of the Related Art

A photovoltaic device may convert optical energy into electric energy. Generally, the photovoltaic device includes a semiconductor layer which may induce photovoltaic effect by absorbing external optical energy, and first and second electrodes between which the semiconductor layer is interposed.

Meanwhile, photoelectric conversion efficiency of the photovoltaic device may be determined by characteristics such as, for example, open circuit voltage, a fill factor, and a short circuit current density. Among them, the short circuit current density may increase by increasing light absorbing efficiency representing quantity of current generated from the photovoltaic device in relation to quantity of light supplied from an exterior to the semiconductor layer. Although the photoelectric conversion efficiency of the photovoltaic device may increase by enlarging the thickness of the semiconductor layer to lengthen a path of light traveling in the semiconductor layer, the manufacturing costs and manufacturing time of the photovoltaic device may increase if the thickness of the semiconductor layer increases. In addition, as the characteristic of the fill factor may degraded, improvement in the photoelectric conversion efficiency may be difficult to obtain.

### SUMMARY

An exemplary embodiment of the present invention may provide a method of manufacturing a photovoltaic device capable of improving photoelectric conversion efficiency.

In accordance with an exemplary embodiment of the present invention, a method of manufacturing a photovoltaic device is provided. The method includes preparing a semiconductor substrate having a light incidence surface receiving light and including single crystalline silicon, wet-etching the light incidence surface to form a plurality of first protrusions on the light incidence surface, dry etching a plurality of surfaces of the plurality of first protrusions to form a plurality of second protrusions on the plurality of surfaces of the first protrusion, and forming a semiconductor layer on the light incidence surface. The method further includes forming a first electrode on the semiconductor layer and forming a second electrode on a rear surface of the semiconductor substrate facing the light incidence surface.

Accordingly, a light introduced into the semiconductor substrate from an exterior through the light incidence surface may be scattered on the light incidence surface by the plurality of first and second protrusions, so that an optical path of the light is lengthened in the semiconductor substrate, thereby improving photoelectric conversion efficiency. As a result, as optical energy is more smoothly absorbed into the semiconductor substrate, the photoelectric conversion efficiency of the photovoltaic device can be improved.

### BRIEF DESCRIPTION OF THE DRAWINGS

Exemplary embodiments of the present invention can be understood in more detail from the following description when considered in conjunction with the accompanying drawings wherein:
FIG. 1 is a sectional view showing an exemplary embodiment of a photovoltaic device according to an exemplary embodiment of the present invention;
FIG. 2A is an enlarged view of first protrusions shown in FIG. 1;
FIG. 2B is an enlarged view of a portion of a sectional surface of the photovoltaic device shown in FIG. 1;
FIG. 3 is a sectional view showing an exemplary embodiment of a photovoltaic device according to the present invention;
FIGS. 4A and 5A are sectional views illustrating an exemplary embodiment of a method of manufacturing the photovoltaic device shown in FIG. 3;
FIG. 4B is a photograph showing a light incidence surface of a semiconductor substrate in the manufacturing step of the photovoltaic device shown in FIG. 4A;
FIG. 5B is a photograph showing a light incidence surface of a semiconductor substrate in the manufacturing step of the photovoltaic device shown in FIG. 5A;
FIGS. 6A to 6C are photographs showing a light incidence surface of a semiconductor substrate according to types of etchant gas used for a dry-etching process; and
FIG. 7 is a graph representing reflective indexes of a semiconductor substrate.

### DESCRIPTION OF THE EXEMPLARY EMBODIMENTS OF THE INVENTION

Hereinafter, exemplary embodiments of the present invention will be described in detail with reference to accompanying drawings. It is understood that the present invention should not be limited to the following exemplary embodiments but various changes and modifications can be made by one ordinary skilled in the art within the spirit and scope of the present invention. The present invention is defined only by the scope of the appended claims. Meanwhile, elements shown in the drawings can be simplified or magnified for the purpose of clear explanation. In addition, the same reference numerals are used to designate the same elements throughout the drawings.

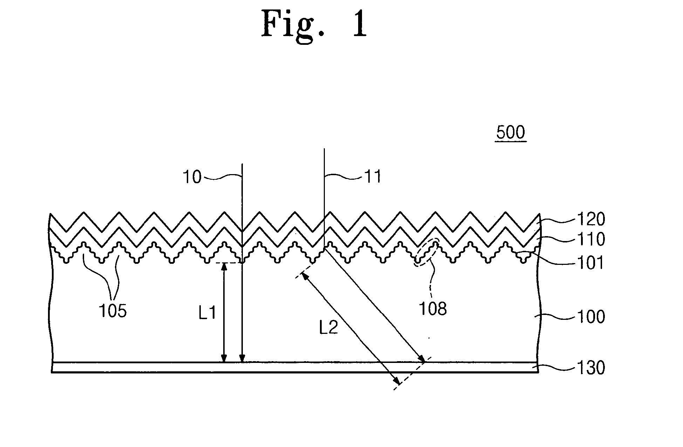

FIG. 1 is a sectional view showing an exemplary embodiment of a photovoltaic device according to the present invention.

Referring to FIG. 1, a photovoltaic device 500 includes a semiconductor substrate 100, a semiconductor layer 110, a first electrode 120, and a second electrode 130.

The semiconductor substrate 100 includes single crystalline silicon, and is formed by doping a 5-group element such as, for example, phosphorus (P) into a silicon wafer, so that the semiconductor substrate 100 has an electric characteristic of an N-type semiconductor. In addition, the semiconductor substrate 100 has a light incidence surface 101 receiving light from an exterior. When the semiconductor substrate 100 receives light from an exterior through the light incidence surface 101, photovoltaic effect may be induced. Through the photovoltaic effect, electrons are created in the semiconductor substrate 100, and emitted to an exterior through the first electrode 120 or the second electrode 130.

The light incidence surface 101 includes first protrusions 105. The first protrusions 105 have a pyramid shape, and have a triangular shape when viewed in a sectional view. The first protrusions 105 may scatter light introduced into the semiconductor substrate 100 from an exterior through the light incidence surface 101 to lengthen an optical path of the light in the semiconductor substrate 100.

For example, when a first light 10 and a second light 11 reach the light incidence surface 101 from an exterior perpendicularly to the semiconductor substrate 100, if the direction of a first optical path L1 of a first light 10 is not changed on the light incidence surface 101, but the direction of a second optical path L2 of a second light 11 is changed on the light incidence surface 101, the second optical path L2 of the second light 11 may be longer than the first optical path L1 of the first light 10. This is because the direction of the second optical path L2 of the second light 11 is inclined with respect to the semiconductor substrate 100 due to one of the first protrusions 105 differently from the direction of the first optical path L1 of the first light 10 that is perpendicular to the semiconductor substrate 100.

If a thickness of the semiconductor substrate 100 increases, a short circuit current density of the photovoltaic device 500 may increase, so that the photoelectric conversion efficiency of the photovoltaic device 500 can be improved. Similarly, if an optical path is lengthened in the semiconductor substrate 100, optical energy may be more smoothly absorbed into the semiconductor substrate 100, and thus the photoelectric conversion efficiency of the photovoltaic device 500 can be improved.

Second protrusions 108 are provided on the surface of the first protrusions 105. The second protrusions 108 may randomly protrude from the surface of the first protrusions 105. The second protrusions 108 have the same function as that of the first protrusions 105. In other words, the second protrusions 108 may scatter light received introduced into the semiconductor substrate 100 from an exterior through the light incidence surface 101. Accordingly, the light introduced into the semiconductor substrate 100 from an exterior through the light incidence surface 101 can be more dispersed by the second protrusions 108 provided on the surface of the first protrusions 105, so that the photoelectric conversion efficiency of the photovoltaic device 500 can be more improved.

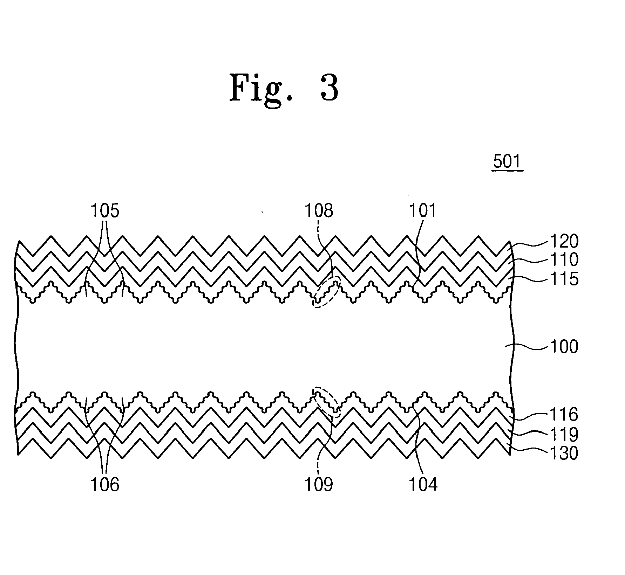

The semiconductor layer 110 is provided above the semiconductor substrate 100. The semiconductor layer 110 includes non-single crystalline silicon such as, for example, amorphous silicon (a-Si) or microcrystalline silicon (µ c-Si). In addition, the semiconductor layer 110 is doped with a 3-group element such as, for example, boron (B) to have an electric characteristic of a P-type semiconductor. Accordingly, the semiconductor layer 110 makes P-N junction with the semiconductor substrate 100 having an electric characteristic of an N-type semiconductor. In addition, to increase photoelectric conversion efficiency, an intrinsic non-single crystalline silicon layer having a thin thickness of, for example, about 20Å to about 100Å may be interposed between the semiconductor substrate 100 having an N-type semiconductor characteristic and the semiconductor layer 110 having a P-type semiconductor characteristic. The structure of a photovoltaic device, in which an intrinsic non-single crystalline silicon layer is interposed between the semiconductor substrate 100 and the semiconductor layer 110, will be described in more detail with reference to FIG. 3.

The first electrode 120 is provided on the semiconductor layer 110. The first electrode 120 includes a transparent conductive material such as, for example, indium tin oxide (ITO), indium zinc oxide (IZO), zinc oxide (ZnO), or tin oxide (SnO₂) such that external light can smoothly reach the semiconductor layer 110 and the semiconductor substrate 100.

The second electrode 130 is provided on a rear surface of the semiconductor substrate 100. The second electrode 130 may include metal, such as, for example, aluminum (Al) or silver (Ag), having high reflectance. The second electrode 130 may include the same material as that of the first electrode 120. Electrons, which are created from the semiconductor substrate 100 and the semiconductor layer 110 due to photovoltaic effect, may be emitted to an exterior through the first and second electrodes 120 and 130.

Meanwhile, the photovoltaic device 500 may further include an N+ non-single crystalline silicon layer, which is interposed between the semiconductor substrate 100 and the second electrode 130, and an intrinsic non-single crystalline silicon layer, which is interposed between the semiconductor substrate 100 and the N+ non-single crystalline silicon layer. The N+ non-single crystalline silicon layer serves as a back surface field (BSF) to improve collection of electrons. A photovoltaic device further including the N+ non-single crystalline silicon layer and the intrinsic non-single crystalline silicon layer will be described in more detail with reference to FIG. 3.

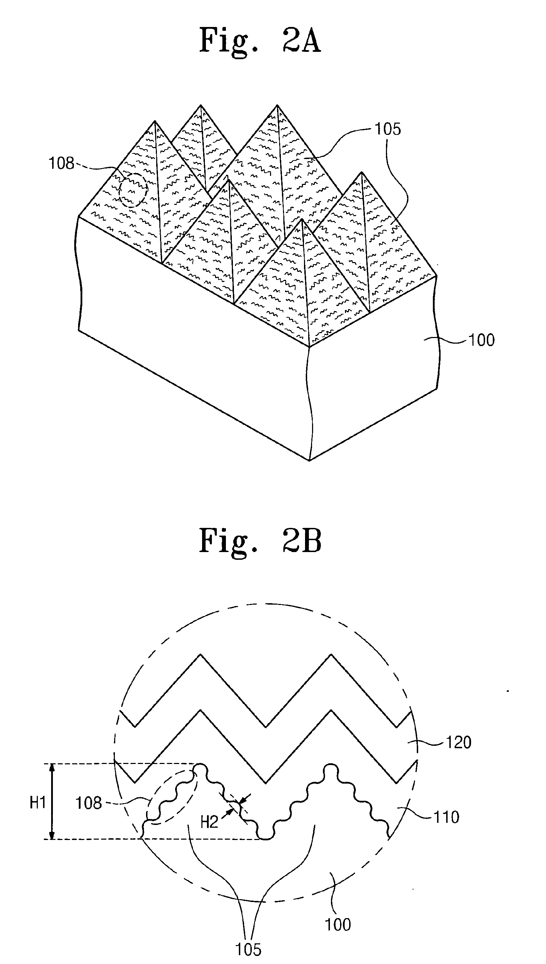

FIG. 2A is an enlarged view of the first protrusions 105 shown in FIG. 1, and FIG. 2B is an enlarged view of a portion of a sectional surface of the photovoltaic device 500 shown in FIG. 1.

Referring to FIGS. 2A and 2B, the first protrusions 105 have a pyramid shape. This is because the etching rate of the semiconductor substrate 100 including single crystalline silicon is higher in a <100> direction than in a <111> direction.

The second protrusions 108 are provided on the surface of the first protrusions 105. The size of the first protrusions 105 is greater than that of the second protrusion 108. For example , when comparing the size of the first protrusions 105 with the size of the second protrusions 108 by using parameters (e.g., height, width, and length) capable of determining the size of a protrusion in general, the size of the first protrusions 105 is greater than that of the second protrusions 108.

A ratio of a first height H1 of the first protrusions 105 to a second height H2 of the second protrusion 108 is in the range of, for example, about 20:1 to about 200:1. For example, the first height H1 is in the range of about 2µm to about 7µm, and the second height H2 is in the range of about 50nm to about 100nm.

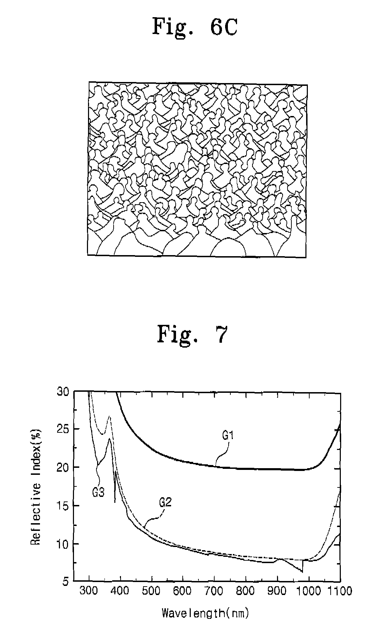

Meanwhile, when light is supplied to the semiconductor substrate 100 through the light incidence surface 101, a reflective index of the light is reduced on the light incidence surface 101 due to the first and second protrusions 105 and 108. As the reflective index of the light is reduced on the light incidence surface 101, quantity of absorbed light used to induce photovoltaic effect may increase in the semiconductor substrate 100, so that the photoelectric conversion efficiency of the photovoltaic device 500 (see FIG. 1) may increase. This will be described in more detail with reference to FIG 7.

FIG. 3 is a sectional view showing another exemplary embodiment of a photovoltaic device according to the present invention. In FIG. 3, the same reference numerals denote the same elements in FIG 1, and thus detailed descriptions of the same elements will be omitted.

Referring to FIG. 3, a photovoltaic device 501 further includes a first intrinsic non-single crystalline silicon layer 115, a second intrinsic non-single crystalline silicon layer 116, and a silicon layer 119 including heavily doped impurities, as compared with the photovoltaic device 500 (see FIG. 1) according to the previous embodiment of the present invention.

The first intrinsic non-single crystalline silicon layer 115 includes intrinsic non-single crystalline silicon such as, for example, amorphous silicon (a-Si) or microcrystalline silicon (µ c-Si), and may have a thickness of, for example, about 20Å to about 100Å. The first intrinsic non-single crystalline silicon layer 115 is interposed between the semiconductor substrate 100 and the semiconductor layer 110 to increase photoelectric conversion efficiency of the photovoltaic device 501 and to reduce contact resistance between the semiconductor substrate 100 and the semiconductor layer 110.

The silicon layer 119 including heavily doped impurities is interposed between the second intrinsic non-single crystalline silicon layer 116 and the second electrode 130. When the semiconductor substrate 100 and the semiconductor layer 110 have N-type and P-type semiconductor characteristics, respectively, the silicon layer 119 including heavily doped impurities includes silicon (such as, for example, N+ non-single crystalline silicon) with impurity concentration greater than that of the semiconductor substrate 100, so that electrons created due to photovoltaic effect are more smoothly emitted to an exterior through the second electrode 130.

The second intrinsic non-single crystalline silicon layer 116 includes intrinsic non-single crystalline silicon such as, for example, amorphous silicon (a-Si) or microcrystalline silicon (µ c-Si). The second intrinsic non-single crystalline silicon layer 116 is formed on a rear surface 104 of the semiconductor substrate 100 to reduce contact resistance between the semiconductor substrate 100 and the silicon layer 119 including heavily doped impurities.

Meanwhile, third protrusions 106 are provided on the rear surface 104, and fourth protrusions 109 are provided on the surface of the third protrusions 106. The third protrusions 106 may have the same shape as that of the first protrusions 105, and the fourth protrusions 109 may have the same shape as that of the second protrusions 108. In addition, similarly to the first and second protrusions 105 and 108, the third and fourth protrusions 106 and 109 increase an optical path in the semiconductor substrate 100 to raise photoelectric conversion efficiency of the photovoltaic device 501.

For example , when the second electrode 130 includes a material (e.g., aluminum (Al) or silver (Ag)) reflecting light according to the present exemplary embodiments, light, which is incident through the light incidence surface 101, but not absorbed in the semiconductor substrate 100, is reflected on the second electrode 130. The light reflected on the second electrode 130 is again scattered by the third and fourth protrusions 106 and 109 Accordingly, an optical path of the light may be increased in the semiconductor substrate 100, so that photoelectric conversion efficiency of the photovoltaic device 501 can be improved.

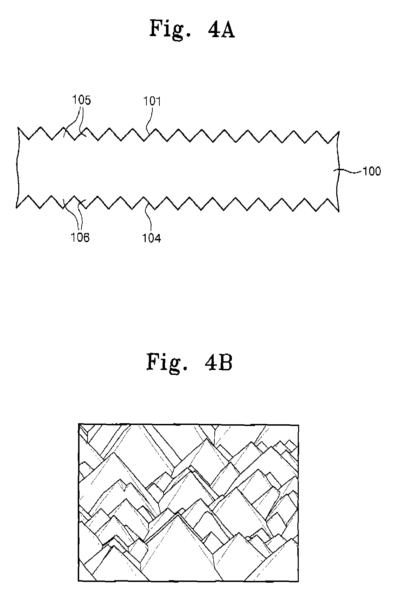

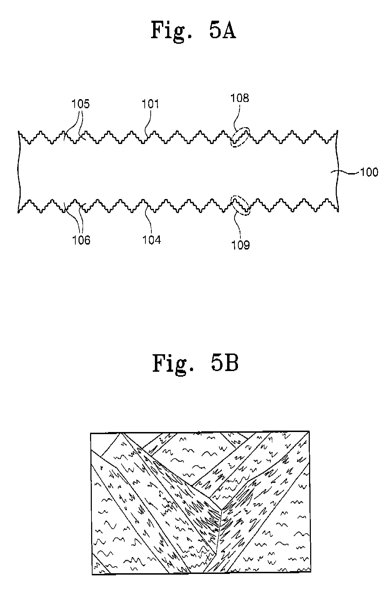

FIGS. 4A and 5A are sectional views illustrating an exemplary embodiment of a method of manufacturing the photovoltaic device 501 shown in FIG. 3, and FIGS. 4B and 5B are photographs showing the light incidence surface 101 of the semiconductor substrate 100 in the manufacturing step of the photovoltaic device 501 of FIGS. 4A and 5A. For example , FIG. 4A is a sectional view showing a process of wet-etching the semiconductor substrate 100, and FIG. 4B is a photograph showing the light incidence surface 101 of the semiconductor substrate 100 after the semiconductor substrate 100 is wet-etched. In addition, FIG. 5A is a sectional view showing a process of dry-etching the semiconductor substrate 100, and FIG. 5B is a photograph showing the light incidence surface 101 of the semiconductor substrate 100 after the semiconductor substrate 100 is dry-etched.

Referring to FIGS. 4A and 4B, the semiconductor substrate 100 having the light incidence surface 101 is wet-etched, so that the first protrusions 105 are formed on the light incidence surface 101. In the present exemplary embodiment, the semiconductor substrate 100 is immersed into a vessel receiving etchant solution such that the semiconductor substrate 100 is etched. As a result, the light incidence surface 101 and the rear surface 104 of the semiconductor substrate 100 facing the light incidence surface 101 are etched by the etchant solution. Accordingly, the third protrusions 106 having the same shape as that of the first protrusions 105 are formed on the rear surface 104.

The etchant solution used to wet-etch the semiconductor substrate 100 may include, for example, an alkaline solution. In more detail, the etchant solution may include, for example, potassium hydroxide (KOH) and isopropyl alcohol (IPA). When the etchant solution includes potassium hydroxide (KOH), as the potassium hydroxide (KOH) provides an etching rate for the semiconductor substrate 100 slower than an etching rate provided by another etchant solution (e.g., sodium hydroxide (NaOH)), the first protrusions 105, which are formed by etching the light incidence surface 101, can have a more uniform size. In addition, when the etchant solution includes the potassium hydroxide (KOH), even if potassium ions (K+) remain on the surface of the semiconductor substrate 100 after the semiconductor substrate 100 is wet-etched, the potassium ions (K+) are less bonded with electrons when compared to other ions (e.g., sodium ions (Na+)). Accordingly, if the etchant solution includes potassium hydroxide (KOH), positive ions generated from the etchant solution are bonded with electrons created due to the photovoltaic effect, so that the reduction of quantity of current in the photovoltaic device 501 can be minimized.

Meanwhile, according to the present exemplary embodiment, although the semiconductor substrate 100 is etched by immersing the semiconductor substrate 100 into etchant solution to form the first protrusions 105, the semiconductor substrate 100 may be etched by spraying the etchant solution to the semiconductor substrate 100.

Referring to FIGS. 5A and 5B, the semiconductor substrate 100 including the first and third protrusions 105 and 106 is dry-etched. Accordingly, the second protrusions 108 are formed on the surface of the first protrusions 105, and the fourth protrusions 109 are formed on the surface of the third protrusions 106.

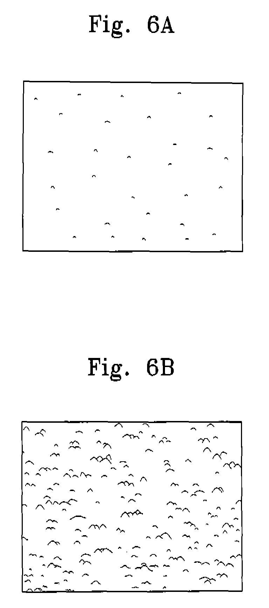

The dry-etching is performed by using, for example, a gas mixture of first gas including fluorine (F) and second gas including chlorine (Cl). In more detail, the first gas may include, for example, sulfur hexafluoride (SF₆), and the second gas may include, for example, chlorine gas (Cl₂). In the mixed gas, the flow rate ratio of the first gas and the second gas is, for example, about 1: 1 to about 3:1. In more detail, preferably, the flow rate ratio of the first gas and the second gas is, for example, about 1: 1. The reason to employ the flow rate ratio of about 1:1 will be described with reference to FIGS. 6A to 6C.

Meanwhile, when the second protrusions 108 are formed by dry-etching the semiconductor substrate 100, edges of the first protrusions 105 are rounded by the second protrusions 108 as shown in FIG. 5B. Accordingly, if the second protrusions 108 are formed on the first protrusions 105, thin films formed on the first protrusions 105 are prevented from being cut by sharp edges of inclined surfaces defining the first protrusions 105 in a region at which the inclined surfaces meet each other.

FIGS. 6A to 6C are photographs showing the light incidence surface 101 (see FIG. 5A) of the semiconductor substrate 100 according to types of etchant gas used for the dry-etching. In more detail, FIG. 6A is a photograph showing a state of the light incidence surface 101 after etching the light incidence surface 101 by applying, for example, chlorine gas (Cl₂) into a plasma dry etching device, which is supplied with RF power of about 2000W under an internal pressure of about 100mT, at a flow rate of about 200 sccm, in which "sccm" represents standard cubic centimeters per minute. FIG. 6B is a photograph showing a state of the light incidence surface 101 after etching the light incidence surface 101 by applying, for example, sulfur hexafluoride (SF₆) into the plasma dry etching device, which is supplied with RF power of about 2000W under an internal pressure of about 100mT, at a flow rate of 200 sccm. FIG. 6C is a photograph showing a state of the light incidence surface 101 after etching the light incidence surface 101 by applying, for example, chlorine gas (Cl₂) and sulfur hexafluoride (SF₆) into the plasma dry etching device, which is supplied with RF power of about 2000W under an internal pressure of about 100mT, at a flow rate of about 200 sccm.

Referring to FIG. 6A, when the semiconductor substrate 100 is dry-etched by using, for example, only chlorine gas (Cl₂), the second protrusions 108 are rarely formed on the light incidence surface 101 of the semiconductor substrate 100. Referring to FIGS. 6B and 6C, the second protrusions 108 are formed on the light incidence surface 101. However, the number of the second protrusions 108 per unit area shown in FIG. 6C is greater than the number of the second protrusions 108 per unit area shown in FIG. 6B. In other words, when the semiconductor substrate 100 is dry-etched by using, for example, gas obtained by mixing chlorine gas (Cl₂) and sulfur hexafluoride (SF₆) at the same flow rate, the texturing effect for the light incidence surface 101 may be maximized.

Referring again to FIGS. 5A and 5B, when the semiconductor substrate 100 is dry-etched to form the second and fourth protrusions 108 and 109, the dry-etching is preferably performed for, example, about 15 seconds to about 120 seconds, in more detail, about 30 seconds. This is because the semiconductor substrate 100 should be subjected to the dry-etching process for at least 15 seconds by taking stabilization time of plasma into consideration. In addition, when the semiconductor substrate 100 is dry-etched for more than about 120 seconds, even if light absorbance of the semiconductor substrate 100 increases with respect to light having a wavelength of about 1000nm or more, the light absorbance of the semiconductor substrate 100 may be reduced with respect to light having a wavelength of about 400nm to about 1000nm, so that the light absorbance is rarely increased over the whole wavelength band of light.

Meanwhile, before the second and fourth protrusions 108 and 109 are formed by dry-etching the semiconductor substrate 100, an oxide layer, which is formed on the semiconductor substrate 100 after the first and third protrusions 105 and 106 are formed, is removed from the surface of the semiconductor substrate 100. The oxide layer may include, for example, silicon oxide (SiOx) formed by combining external oxygen (O) with silicon (Si) of the semiconductor substrate 100. The oxide layer may be etched by using, for example, boron trichloride (BCl₃) or a gas mixture of boron trichloride (BCl₃) and chlorine gas (Cl₂).

Referring again to FIG. 3, the first intrinsic non-single crystalline silicon layer 115 is formed on the light incidence surface 101 of the semiconductor substrate 100, the semiconductor layer 110 having a P-type semiconductor characteristic is formed on the first intrinsic non-single crystalline silicon layer 115, and the first electrode 120 is formed on the semiconductor layer 110. In addition, the second intrinsic non-single crystalline silicon layer 116 is formed on the rear surface 104 of the semiconductor substrate 100, the silicon layer 119 including heavily doped impurities is formed on the second intrinsic non-single crystalline silicon layer 116, and the second electrode 130 is formed on the silicon layer 119 including heavily doped impurities, thereby manufacturing the photovoltaic device 501.

FIG. 7 shows first to third curves G1, G2, and G3 representing reflective indexes of the semiconductor substrate 100. In more detail, FIG. 7 shows the first to third curves G1, G2, and G3 showing the reflective indexes of the semiconductor substrate 100 obtained from experiment according to three states of the light incidence surface 101 of the semiconductor substrate 100.

Referring to FIG. 7, the reflective indexes of the semiconductor substrate 100 (see FIG. 1) according to wavelengths of light are classified according to three states of the light incidence surface 101 (see FIG. 1) of the semiconductor substrate 100 (see FIG. 1). For the convenience of the explanation, the three states are classified into first to third surface states. The first to third curves G1 to G3 represent reflective indexes of the semiconductor substrate 100 having the first to third surface states, respectively.

The first surface state represents a flat surface of the light incidence surface 101 when the light incidence surface 101 is not subject to any etching processes. The second surface state represents a state of the light incidence surface 101 when the light incidence surface 101 is wet-etched to form the first protrusions 105 (see FIG. 4A) on the light incidence surface 101. The third surface state represents a state of the light incidence surface 101 when the light incidence surface 101 is wet-etched and dry-etched, so that the first protrusions 105 are formed on the light incidence surface 101, and the second protrusions 108 (see FIG. 5B) are formed on the surface of the first protrusions 105.

Referring to the first to third curves G1 to G3, the reflective index of the semiconductor substrate 100 having the second surface state is lower than the reflective index of the semiconductor substrate 100 having the first surface state over the whole wavelength region of light. In addition, the reflective index of the semiconductor substrate 100 having the third surface state is lower than the reflective index of the semiconductor substrate 100 having the second surface state over the whole wavelength region of the light. In particular, regarding light having wavelengths in the range of about 250nm to about 400nm and the range of about 900nm to about 1100nm, the reflective index of the semiconductor substrate 100 having the third surface state is significantly lower than the reflective index of the semiconductor substrate 100 having the second surface state. In other words, when the second protrusions 108 (see FIG. 5B) are additionally formed by dry-etching the semiconductor substrate 100 after the first protrusions 105 (see FIG. 4) are formed by wet-etching the semiconductor substrate 100, the semiconductor substrate 100 can absorb much more of the light in a specific wavelength band.

Having described the exemplary embodiments of the present invention, it is further noted that it is readily apparent to those of reasonable skill in the art that various modifications may be made without departing from the spirit and scope of the invention which is defined by the metes and bounds of the appended claims.

## Claims

1. A method of manufacturing a photovoltaic device, the method comprising:
preparing a semiconductor substrate having a light incidence surface receiving a light, and including single crystalline silicon;
wet-etching the light incidence surface to form a plurality of first protrusions on the light incidence surface;
dry-etching a plurality of surfaces of the plurality of first protrusions to form a plurality of second protrusions on the plurality of surfaces of the plurality of first protrusions;
forming a semiconductor layer on the light incidence surface;
forming a first electrode on the semiconductor layer; and
forming a second electrode on a rear surface of the semiconductor substrate facing the light incidence surface.

2. The method of claim 1, wherein a height ratio of the plurality of first protrusions to the plurality of second protrusions is in a range of about 20:1 1 to about 200:1.

3. The method of claim 2, wherein a height of the plurality of first protrusions is in a range of about 2µm to about 7µm.

4. The method of claim 3, wherein a height of the plurality of second protrusions are in a range of about 50nm to about 100nm.

5. The method of claim 1, wherein an etchant used for the wet-etching comprises potassium hydroxide (KOH).

6. The method of claim 1, further comprising:
forming a plurality of third protrusions on a rear surface of the semiconductor substrate , wherein the plurality of third protrusions have a same shape as a shape of the plurality of first protrusions; and
dry-etching the surfaces of the plurality of third protrusions to form a plurality of fourth protrusions on the plurality of surfaces of the plurality of third protrusions,
wherein the plurality of third protrusions are formed together with the plurality of first protrusions.

7. The method of claim 1, wherein an etchant used for the dry-etching comprises a gas mixture of a first gas comprising fluorine (F) and a second gas comprising chlorine (Cl).

8. The method of claim 7, wherein the first gas comprises sulfur hexafluoride (SF₆), and the second gas comprises chlorine (Cl).

9. The method of claim 8, wherein a flow rate ratio of the first gas to the second gas is in a range of about 1: 1 to about 3:1.

10. The method of claim 9, wherein the dry-etching is performed for about 15 seconds to 120 seconds.

11. The method of claim 1, wherein the semiconductor layer comprises non-single crystalline silicon, and is formed through a chemical vapor deposition scheme.

12. The method of claim 1, wherein the semiconductor substrate is an N-type semiconductor, and the semiconductor layer is a P-type semiconductor.

13. The method of claim 1, further comprising:
forming a first intrinsic non-single crystalline silicon layer between the semiconductor substrate and the semiconductor layer;
forming a second intrinsic non-single crystalline silicon layer between the semiconductor substrate and the second electrode; and
forming a silicon layer comprising heavily doped impurities between the second intrinsic non-single crystalline silicon layer and the second electrode, the silicon layer having an impurity concentration greater than an impurity concentration of the semiconductor substrate.

14. The method of claim 1, further comprising removing an oxide layer formed on the semiconductor substrate by using an etchant comprising one of boron trichloride (BCl₃) or a gas mixture of boron trichloride (BCl₃) and chlorine gas (Cl₂), before the dry-etching is performed.
